Europäisches Patentamt

European Patent Office

Office européen des brevets

(11) Veröffentlichungsnummer: **0 177 731**
**A2**

(12) **EUROPÄISCHE PATENTANMELDUNG**

(21) Anmeldenummer: 85110761.5

(22) Anmeldetag: 27.08.85

(51) Int. Cl.⁴: **H05K 7/14**

(30) Priorität: 26.09.84 DE 3435360

(43) Veröffentlichungstag der Anmeldung:
16.04.86 Patentblatt 86/16

(84) Benannte Vertragsstaaten:
AT CH DE FR GB IT LI SE

(71) Anmelder: **Siemens Aktiengesellschaft**
**Berlin und München Wittelsbacherplatz 2**
**D-8000 München 2(DE)**

(72) Erfinder: **Pelzl, Leo, Ing.grad.**
**Alpenblickstrasse 5**
**D-8150 Holzkirchen(DE)**
Erfinder: **Seibold, Jürgen, Ing.grad.**
**Fichtenstrasse 1**
**D-8021 Baierbrunn(DE)**
Erfinder: **Zell, Karl, Ing.grad.**
**Moritz-von-Schwind-Weg 80**
**D-8134 Niederpöcking(DE)**

(54) Einschiebbare elektrische Baugruppe.

(57) Die Baugruppe ist mit einer mehrreihigen Steckerleiste versehen, die an eine Trägerplatte (6) angeschlossen ist, welche im Verlängerungsbereich einer mittleren Kontaktreihe verlaufend angeordnet ist. Die Anschlußelemente (5) der äußeren Reihe von Kontaktelementen (3) sind bis in den Bereich der nächsten Reihe hinein um das Leiterplattenende herumgebogen und von der gleichen Seite her wie die Anschlußelemente (5) der übrigen Reihen in Bohrungen (7) der Leiterplatte (6) eingesetzt. Die beiden äußeren, der Leiterplatte (6) benachbarten Reihen von Aufnahmekammern (2) sind abwechselnd und versetzt zueinander mit Kontaktelementen (3) bestückt.

Durch die Erfindung wird die Leiterplatte von der Trennungsgrenze, weg nach innen versetzt. Die Steckkräfte werden weniger einseitig auf die Leiterplatte übertragen.

FIG 1

EP 0 177 731 A2

Einschiebbare elektrische Baugruppe

Die Erfindung bezieht sich auf eine einschiebbare elektrische Baugruppe nach dem Oberbegriff des Patentanspruches.

Es ist bekannt, die Trägerplatten fluchtend zur Längsseitenfläche der Steckerleiste anzuordnen. Dabei kann es vorkommen, daß die Leiterplatte bis in den Bereich der benachbarten äußeren Kammerreihe hineinreicht. Jedoch bleibt dann immer noch ein genügender Freiraum, um die Anschlußelemente geradlinig an der Leiterplatte entlang bis zu den Bohrungen zu führen, in die sie eingesetzt sind. Bei einer derartigen Anordnung besteht die Gefahr, daß die aus der Leiterplatte herausragenden Enden der Anschlußelemente, sowie die durch die Leiterplatte hindurchragenden Enden der Bauelemente, mit denen die Leiterplatte bestückt ist, in den Teilungsbereich der benachbarten Baugruppe hineinragen. Insbesondere beim Einschieben der Baugruppe zwischen zwei bereits eingeschobenen benachbarten Baugruppen kann es zu gegenseitigen Berührungen kommen.

Der Erfindung liegt die Aufgabe zugrunde, den Aufbau der Baugruppe zu verbessern und die Gefahr der Beeinträchtigung zu vermeiden.

Diese Aufgabe wird durch die im Kennzeichen des Patentanspruches angegebenen Merkmale gelöst. Die Leiterplatte ist nun vom Rand der Steckerleiste weg nach innen gerückt. Sie überdeckt mit ihrer Stirnseite einen Teil der längsten Kammernreihe. Die durch die Leiterplatte hindurchragenden Enden der Anschlußelemente haben einen genügenden Abstand zur durch die Längsseite der Steckerleiste vorgegebene Teilungsgrenze. Beim Aufstecken der Baugruppe auf die Steckeinrichtung der Magazinrückwand kommt es zu einer weniger einseitigen Kraftverteilung, da die Leiterplatte, über die die Steckkräfte weitergeleitet werden, zur Mitte der Stekkerleiste hin versetzt ist.

Aus fertigungstechnischen Gründen ist es zweckmäßig, die Enden der Anschlußelemente alle von einer Seite her in die zugehörigen Bohrungen der Leiterplatte einzusetzen. Das bedeutet, daß die Anschlußelemente der äußeren Reihe zumindest bis in den Bereich der nächsten Reihe von Anschlußelementen hineingebogen werden müssen. Durch die Belegung der Aufnahmekammern abwechselnd und versetzt zueinander wird eine gegenseitige Berührung vermieden. Die Kontaktelemente dieser beiden Reihen haben nun einen größeren Abstand zueinander, so daß die Gefahr von gegenseitiger elektrischer Beeinflussung verringert wird. Aus diesem Grunde werden diesen beiden Reihen die elektrisch besonders gefährdeten Leitungen zugeordnet.

Im folgenden wird die Erfindung anhand eines in der Zeichnung dargestellten Ausführungsbeispieles näher erläutert.

Fig. 1 zeigt einen Teilschnitt durch eine einschiebbare elektrische Baugruppe mit einer Steckerleiste,

Fig. 2 zeigt einen Teilschnitt durch die Steckerleiste entlang der Linie II-II in Fig. 1.

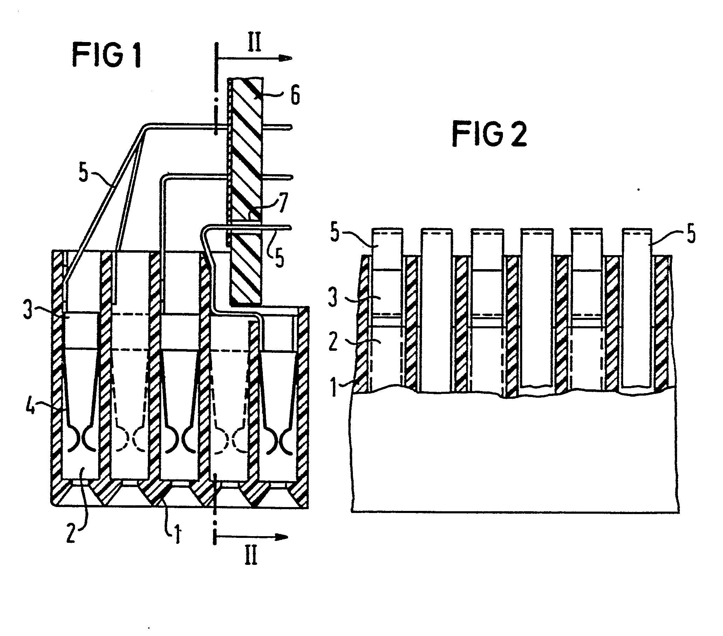

Nach den Fig. 1 und 2 besteht eine Steckerleiste einer einschiebbaren elektrischen Baugruppe aus einem Gehäuse 1 mit mehreren Reihen von Aufnahmekammern 2 für Kontaktelemente 3. Diese sind einstückig aus Kontaktfedern 4 und Anschlußelementen 5 gebildet. Die freien Enden der Anschlußelemente sind rechtwinkelig zu den Aufnahmekammern 2 abgebogen und von einer Seite her in Bohrungen 7 einer Leiterplatte 6 eingesetzt. Diese ist im Verlängerungsbereich einer zweitäußeren Reihe von Aufnahmekammern verlaufend angeordnet. Die Anschlußelemente 5 der benachbarten äußeren Reihe sind bis auf die gegenüberliegende Seite der Trägerplatte 6 U-förmig um deren Ende herumgebogen und verdecken dadurch die Aufnahmekammern 2 der nächsten Reihe. Die Aufnahmekammern 2 dieser beiden Reihen sind abwechselnd versetzt zueinander mit Kontaktelementen 3 bestückt, so daß sich die Anschlußelemente 5 gegenseitig nicht berühren können. Diese beiden Reihen von Kontaktelementen sind vorzugsweise mit elektrisch besonders beanspruchten Leitungen verbunden.

**Ansprüche**

Einschiebbare elektrische Baugruppe mit einer Trägerplatte und einer an diese angesetzten Steckerleiste, die mit mehreren Reihen von rasterartig angeordneten Aufnahmekammern für Kontaktelemente versehen ist, deren rechtwinkelig abgebogene Anschlußelemente von einer Seite her in Bohrungen der Trägerplatte eingesetzt sind, **dadurch gekennzeichnet,** daß die Trägerplatte (6) im Verlängerungsbereich einer inneren Reihe von Aufnahmekammern (2) angeordnet ist, daß die Anschlußelemente (5) der äußeren auf der den freien Enden der Anschlußelemente (5) zugewandten Seite der Trägerplatte (6) liegenden Reihe U-förmig um das Trägerplattenende herumgebogen sind und daß die Aufnahmekammern (2) dieser Reihe und zumindest der anschließenden Reihe abwechselnd und zueinander versetzt von Kontaktelementen (3) frei gehalten sind.

**FIG 1**

**FIG 2**